# EUROPÄISCHE PATENTSCHRIFT

(11) **EP 3 220 547 B1**
(45) Veröffentlichungstag und Bekanntmachung des Hinweises auf die Patenterteilung: **25.11.2020**
(21) Anmeldenummer: 17160226.1
(22) Anmeldetag: 10.03.2017
(51) Int. Cl.: H03K 17/96

(54) **ORTSFEST INSTALLIERBARES ELEKTRISCHES SCHALTGERÄT**
ELECTRICAL SWITCHING APPARATUS WHICH CAN BE INSTALLED IN A FIXED LOCATION
APPAREIL DE COMMUTATION ÉLECTRIQUE À INSTALLER À DEMEURE

(30) Priorität: 16.03.2016 DE 102016003182
(43) Veröffentlichungstag der Anmeldung: 20.09.2017
(73) Patentinhaber: ABB Schweiz AG, 5400 Baden (CH)
(72) Erfinder: Wieske, Stefan, 58285 Gevelsberg (DE); Lehnert, Christian, 58239 Schwerte (DE); Fröhling, Marcel, 58579 Schalksmühle (DE); Krummel, Holger, 58515 Lüdenscheid (DE)
(74) Vertreter: Wesch, Arno

(56) Entgegenhaltungen:
- WO-A1-2014/057010
- DE-A1- 10 307 473
- DE-A1- 19 941 251
- DE-A1-102007 019 505

## Beschreibung

Die Erfindung betrifft ein ortsfest installierbares elektrisches Schaltgerät, insbesondere einen Installationsschalter oder ein Gebäudeautomatisierungsgerät, der Haus- oder Gebäudeinstallation, gemäß den Merkmalen des Anspruches 1. Das erfindungsgemäße Schaltgerät wird in Schaltern von Unterputz- und Aufputzinstallationsgeräten, wie beispielsweise bei Schaltern mit einer oder mehreren Schaltkammern, Schaltern mit einer oder mehreren Schaltwippen, Einfachschaltern, Dimmschaltern, Wechsel- bzw. Zwischenstellungsschaltern oder Doppel- bzw. doppelpoligen Schaltern eingesetzt, betrifft aber auch Gebäudeautomatisierungsgeräte und deren Bedienelemente, wie beispielsweise für Sonnenschutzvorrichtungen, Heizung- und Klimaanlagen, Türkommunikationsanlagen und Sicherheitsanlagen.

Elektrische Schaltgeräte der Haus- oder Gebäudeinstallation sind als rahmengebundene Unterputz-Programme, wie beispielsweise die Schalterprogramme "Solo" und "Busch-balance" oder als rahmenlose Unterputz-Programme, wie "priON" und "triton" sowie als Aufputzprogramm wie "Ocean" der Firma Busch-Jaeger GmbH bekannt. Ebenfalls bekannt sind transparente Schalter mit Design-Einlegern im Schalter-Rahmen der Firma Merten GmbH als auch die Bedienung elektrischer Schaltgeräte, beispielsweise durch mechanische Wippen, Taster, Touchflächen oder berührungslos arbeitende Schalter.

Dabei sind diese Geräte typischerweise aus einem Funktionseinsatz als Schalteinsatz mit darauf angeordnetem Tragrahmen und einem auf den Schalteinsatz aufsteckbaren Bedienteil, z.B. einer Wippe oder eines Tasters, aufgebaut und oft auch durch einen Abdeckrahmen komplettiert, welcher als Designelement der unterschiedlichen Schalterprogramme genutzt wird.

Die Bedienteile sind jeweils ortsunveränderlich am Gerät angebracht und auf Grund ihrer speziellen Abmessungen, Materialien sowie Form- und Farbgestaltungen nicht in anderen Schaltprogrammen verwendbar.

Aus der DE 199 41 251 A1 sind durchsichtige Funktionsscheiben bekannt, die jeweils unterschiedliche Adaptereinheiten an einem Trägergehäuse benötigen. Die DE 10 2007 019 505 A1 zeigt ein Installationsgerät mit OLED-Leuchtmitteln und die DE 103 07 473 A1 zeigt Eingabegeräte, die unter einer Wand verborgen sind.

Der Erfindung liegt daher die Aufgabe zugrunde, ein kostengünstiges, elektrisches Schaltgerät gemäß den Merkmalen des Anspruches 1 anzugeben, welches vorab genannte Nachteile vermeidet und dessen Bedienteil lösbar und weitgehend unauffällig, am Schaltgerät anbringbar ist. Das elektrische Schaltgerät findet insbesondere in Zweckbauten, wie beispielsweise Hotels, Flughäfen, Büro- oder Industriegebäuden, Krankenhäusern und Altenheimen Anwendung.

Diese Aufgabe wird durch ein ortsfest installierbares elektrisches Schaltgerät, insbesondere einen Installationsschalter oder ein Gebäudeautomatisierungsgerät, gelöst, das die im Anspruch 1 angegebenen Merkmale aufweist. Vorteilhafte Ausgestaltungen dieses erfindungsgemäßen Elektroinstallationsgerätes sind in weiteren Ansprüchen angegeben.

Erfindungsgemäß ist das elektrische Schaltgerät, das als Unterputz- oder Aufputz-Installationsgerät ausgeführt ist, aus wenigstens einem ortsfest installierten ersten Schaltteil und wenigstens einem vom ortsfesten ersten Schaltteil abnehmbaren zweiten Schaltteil aufgebaut Das wenigstens eine zweite Schaltteil ist aus einem im wesentlichen transparenten, farblosen, farbig transparenten oder klar durchsichtigen Material gefertigt und weist wenigstens eine berührungsempfindliche Schaltfläche bzw. Touch- Fläche auf, mit der eine oder mehrere Bedienungen des Schaltgerätes ohne mechanische Schaltbewegung am als Bedienteil ausgeführten zweiten Schaltteil ausführbar sind.

Die Ausführung des zweiten Schaltteils aus transparentem Material, zu denen Glassubstrate, Metalloxidsubstrate und Polymersubstrate zählen, ermöglicht in vorteilhafter Weise, dass das zweite Schaltteil frei schwebend auf seinem Untergrund bzw.

Hintergrund platziert werden kann und sich damit weitgehend unauffällig in die Wandoptik bzw. Umgebung eines Gebäudeteiles integrieren lässt.

Das ortsfest installierte erste Schaltteil ist vorzugsweise als Unterputzkomponente realisiert, kann aber auch als Aufputzkomponente, beispielsweise für die einfache Rennovation, ausgeführt sein.

Erfindungsgemäß ist das zweite Schaltteil bzw. Bedienteil aus einem transparenten Grundkörper aufgebaut.

Der im wesentlichen transparente Grundkörper kann beispielsweise aus einem Kunststoff mit darauf aufgebrachten leitfähigen Polymer-Beschichtungen aufgebaut sein, welche beispielsweise das in der EP 0 339 340 A2 beschriebene Polyethylen-3, 4-di-oxythiophen (PEDOT oder PEDT) oder die in der EP 0 440 957 A2 offenbarten Dispersionen von PEDOT mit Polyanionen, wie z.B. Polystyrolsulfonsäure (PSS), verwendet.

Die leitfähige Polymer-Beschichtung kann durch unterschiedliche Verfahren, wie beispielsweise Aufsprühen, Siebdruck, Inkjetdruck, Tampondruck, Tiefdruck, Rakelstreichverfahren, Sputtern, oder Spin/Dip.Coating, auf den Grundkörper aufgebracht werden. Es kann jedoch jedes beliebige geeignete Verfahren Anwendung finden.

Der Grundkörper ist vorzugsweise aus Kunststoff, einem Glassubstrat oder einem Metalloxid mit einer starren, festen Oberfläche aber auch als Kunststofffolie oder flexibles Glassubstrat mit einer flexiblen, biegbaren Oberfläche ausgeführt, wobei sowohl rechteckförmige, quadratische, dreieckförmige oder runde Bedienteile bzw. beliebig geformten Bedienflächen gestaltbar sind.

Das als Bedienteil ausgeführte zweite Schaltteil kann einen flachen Aufbau mit einem nahezu zweidimensionalen Grundkörper als auch mit einem dreidimensionalen räumlichen Grundkörper ausgebildet sein und optional eine Laserbeschriftung, einen Tampondruck, eine Gravierung, einen Siebdruck, einen Digitaldruck sowie alle anderen geeigneten Verfahren sowie Elemente für Beschriftungseinleger mit beispielsweise Texten und/oder Symbolen aufweisen.

In einer ersten Ausführungsform weist das zweite Schaltteil bzw. Bedienteil lediglich elektrisch leitfähige Schichten ohne zusätzliche elektronische Komponenten, wie RFID-Tags, LEDs, OLEDs, auf.

In einer vorteilhaften zweiten Ausführungsform des erfindungsgemäßen Schaltgerätes sind im zweiten Schaltteil elektronischen Komponenten, wie beispielsweise RFID-Tags, Beleuchtungskörper (z.B. LEDs, OLEDs) für eine Statusanzeige, Antennenelemente für Funk- Sensoriken und/oder ein vorzugsweise als Touchfläche ausgeführtes, vorzugsweise als transparentes, Display vorgesehen.

Auch Designeinlegeelemente, wie beispielsweise Elemente in unterschiedlicher Farbgestaltung, unterschiedlicher Struktur bzw. mit einem individualisierten Design lassen sich im transparent ausgeführten Bedienteil realisieren.

Erfindungsgemäß kann das transparente Bedienteil mittels integrierter Beleuchtungselemente, beispielsweise LEDs, OLEDs und /oder durch Beleuchtungselemente, welche in das erste Schaltteil integriert sind, vollflächig und/oder in einer oder mehreren Teilflächen, beispielsweise für eine Statussignalisierung, wie Symbole, Beschriftungen usw. illuminiert, ausgeführt sein.

Die mit der Erfindung erzielbaren Vorteile bestehen insbesondere darin, dass ein kostengünstiges, transparentes, austauschbares, mobiles, modulares, formunabhängiges und personalisierbares Bedienelement für ein neuartiges Schalterdesign bereitgestellt wird.

Das als portables bzw. mobiles (Teil-) Gerät austauschbare Bedienteil ist mit wenigstens einer "mitnehmbaren Schaltfläche" gestaltet, so dass sich die Bedienfläche für das Schaltgerät gegen eine Bedienfläche mit anderen Bedienelementen austauschen lässt, indem das Bedienteil vom ortsfest installierten ersten Schaltteil getrennt bzw. abgezogen wird und durch ein anderes Bedienteil mit anderen Schaltflächen ersetzt wird.

Durch zuvor genanntes Verfahren lässt sich der ortsfeste Schalter sowohl personalisieren (beispielsweise Anzahl, Art- und Weise der Funktionsflächen), als auch in seiner Funktion verändern (beispielsweise wird ein Lichtschalter zu einem Dimmer), wenn dieser, vorzugsweise als busfähiger, Schalter ausgeführt ist.

Das vom ersten Schaltteil entfernbare Bedienteil ist mit einer Mitnahmefunktion und einer Personalisierungsfunktion des elektronischen Schalters ausgestattet.

Durch die Trennung von erstem und zweitem Schaltteil kann die jeweilige Schaltfunktion getauscht, mitgenommen oder mitgebracht werden, indem beispielsweise Personen mit gleichem oder unterschiedlichem Bedienteil und/oder damit verbunden Berechtigung ausgestattet sind. Ohne das entsprechende Bedienteil ist somit eine Schaltfunktion vor Ort nicht gegeben.

Durch die im zweiten Schaltteil integrierte Personalisierungsfunktion, die ein personalisiertes Bedienlayout bedingt, ist ein Zugriff auf verschiedene Gebäude- oder Raumfunktionen, zu denen u.a. die Raumbeleuchtung, Jalousiesteuerung, Türöffnungseinheiten zählen, über unterschiedliche Bedienteilausgestaltungen für unterschiedliche Nutzer möglich. Beispielsweise sind in einer Ausführungsform des Bedienteils für ein Reinigungsteam nur Schaltflächen für die Raumbeleuchtung aufgebracht, während eine andere Ausführungsform des Bedienteiles für den Hausmeister auch ein Zugriff auf Solltemperatureinstellungen, Diagnosefunktionen und/oder Funktionen für Wartungsaufgaben, wie z.B. Betriebsstunden der Beleuchtungseinheiten und deren Wechselintervalle auf dem Bedienteil, vorgesehen ist. Jedes der beiden mit unterschiedlichen Funktionen ausgestatteten Bedienteile lässt sich jedoch erfindungsgemäß am gleichen fest installierten ersten Schaltteil anbringen.

In einer besonders vorteilhaften Ausgestaltung des erfindungsgemäßen Schaltgerätes wird dadurch, dass das zweite Schaltteil mobil ist, eine Diebstahlsfunktion dahingehend realisiert, dass nach dem ersten Zusammenbringen des zweiten Schaltteils mit dem ersten Schaltteil, das zweite Schaltteil mit dem ersten Schaltteil fest bzw. unlösbar verbunden bleibt. Um dennoch für den Renovationsfall das zweite Schaltteil wieder vom ersten Schaltteil zu lösen, sollte dieses nur durch den Einsatz eines zusätzlichen dafür spezialisierten Werkzeugs ermöglicht sein.

Weiterhin können auf dem Bedienteil verschiedene Bedienfunktionen realisiert sein, wie beispielsweise eine 2-fach oder mehrfach Schaltfläche für einen 1-fach oder mehrfach Schalter, ein gerader Schieberegler oder ein kreisförmiger Schieberegler für einen Drehregler bzw. Dimmer.

Eine weitere alternative Ausgestaltung des zweiten Schaltteils ist als reine Anzeige ausgeführt, indem beispielsweise die Raumtemperatur und/oder die CO2 Konzentration visualisierbar ist.

Insbesondere wenn das Bedienteil keine zusätzlichen elektronischen Komponenten aufweist, ist seine Herstellung als beschichteter Kunststoff mit integrierten leitfähigen Schichten, wie beispielsweise als Clevios™- beschichtete PET- Folie, in einfacher und kostengünstiger Weise realisierbar.

Auch der Einsatz als Schalter für Haushaltgeräte, wie beispielsweise Küchenherde oder Kochinseln ist vom erfindungsgemäßen Schaltgerät mit umfasst. Dabei kann eine ortsfeste Komponente für spezielle Küchenfunktionen auf der Arbeitsplatte der Küche montiert sein und das portable Bedienteil wird eingesteckt, wenn beispielsweise gekocht wird, um den Herd zu steuern und/oder ein Kochrezept aufzurufen und an einem entfernten Display darzustellen.

Anhand von den in den folgenden Figuren dargestellten Ausführungsbeispielen sollen die Erfindung sowie vorteilhafte Ausgestaltungen, Verbesserungen und weitere Vorteile der Erfindung näher erläutert und beschrieben werden. Es zeigen:
- **Fig.** 1: eine schematische Darstellung eines beispielhaften erfindungsgemäßen Schaltgerätes in der Ausführung als Unterputz- Installationsgerät,
- **Fig.** 2: eine beispielhafte Schnittdarstellung des erfindungsgemäßen Schaltgerätes, welches in bei dem das in einem Unterputzeinsatz befindliche erste Schaltteil lösbar mit dem zweiten Schaltteil verbunden ist,
- **Fig.** 3: eine schematische Darstellung einer beispielhaften mehrschichtigen Struktur des portablen Bedienteiles und seine elektrische Verbindung/Kontaktierung mit dem ortsfest installierten ersten Schaltteil, und
- **Fig.** 4: einen beispielhafter Aufbau einer beschichteten als Bedienteil des elektrischen Schaltgerätes vorgesehenen Kunststofffolie mit integrierten leitfähigen Schichten.

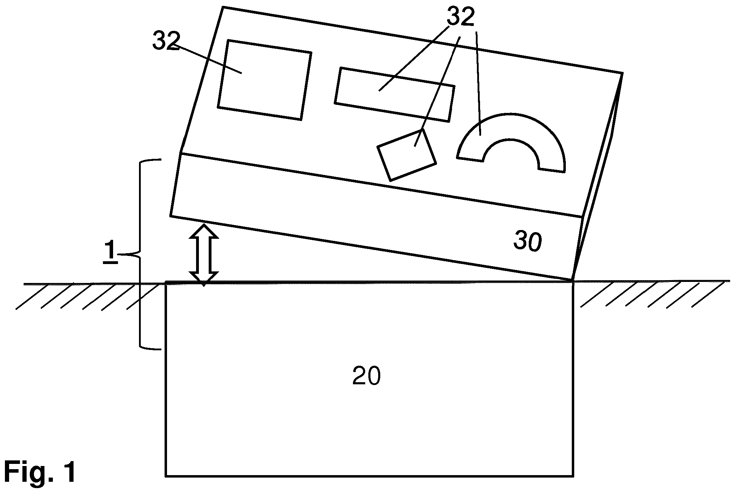

In der **Fig.** 1 ist eine Ausführungsform des erfindungsgemäßen Schaltgerätes 1 in der Ausführung als Unterputz- Installationsgerät gezeigt, welches aus einem ortsfest installierbaren ersten Schaltteil 20 und einem vom ortsfest installierbarem ersten Schaltteil 20 abnehmbaren zweiten Schaltteil 30 aufgebaut ist. Das zweite Schaltteil 30 ist aus einem transparenten Material gebildet und an seiner Außenseite mit mehreren berührungsempfindlichen Schaltflächen 32 ausgestattet, mit dem eine Bedienung des Schaltgerätes ausführbar ist.

Im ortsfest installierten Schaltteil 20 befindet sich ein Funktionseinsatz, der beispielsweise ein Schalteinsatz, ein Netzteil, Busankopplungselemente für eine drahtlose oder drahtgebundene Datenübertragung, ein Speicherbaustein, ein Mikroprozessor, ein Lautsprecher und/oder ein Mikrofon sein kann.

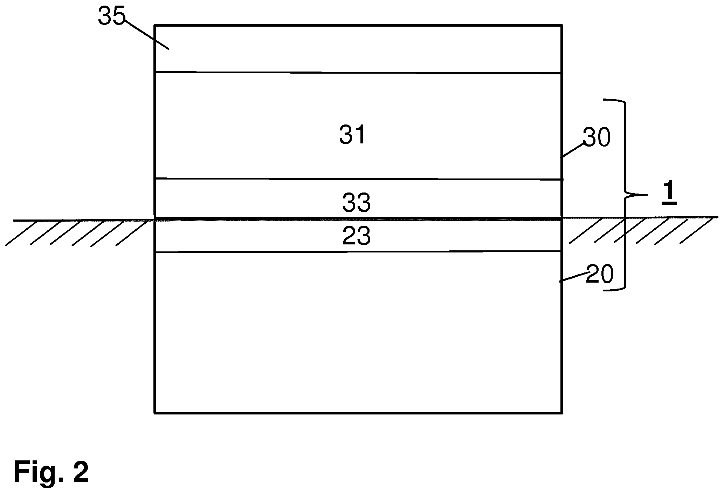

Das Bedienteil 30 des Schaltgerätes 1 ist mit einer elektromechanischen Schnittstelle 33 für die elektrische und mechanische Kontaktierung mit dem ortsfest installierten ersten Schaltteil 20 über dessen elektromechanische Schnittstelle 23 ausgestattet. Dies ist in der **Fig.** 2 gezeigt.

Das Bedienteil 30 aus dem Grundkörper 31 und der darauf aufgebrachten Bedienfläche 35 aus einer leitfähigen Polymer-Beschichtung 35 aufgebaut, welche beispielsweise auch als Touch- Display ausgeführt ist.

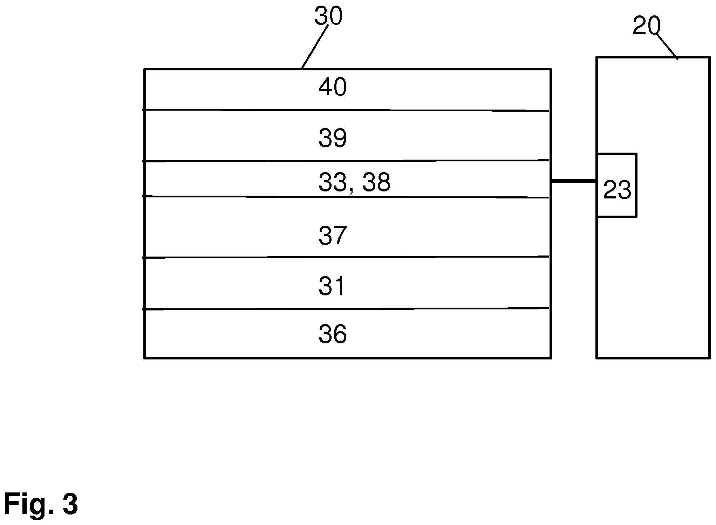

**Fig.** 3 zeigt eine schematische Darstellung einer beispielhaften mehrschichtigen Struktur des portablen Bedienteiles 30 und seine elektrische Verbindung/ Kontaktierung mit dem ortsfest installierten ersten Schaltteil 20. Die Struktur umfasst übereinander angeordnete Schichten unterschiedlicher Funktion, deren transparenter Grundkörper 31, beispielsweise aus einem Glassubstrat, einem thermoplastischem Kunststoff, wie Polycarbonat (PC), Polyethylen (PE), oder einem synthetischen Kunststoff, wie Polymethylmethacrylat (PMMA) besteht. Hierbei handelt es sich um nicht einschränkende Beispiele.

Auf den Grundkörper 31 ist eine Schicht bzw. Lage für integrierte Bedienelemente 38 mit den Funktionsflächen für Schaltflächen 32 und Kontaktierungselementen 33 zum Schaltteil aufgebracht.

Optional ist zwischen dem Grundkörper 31 und der Schicht bzw. Lage für integrierte Bedienelemente 38 eine weitere Schicht bzw. Lage 37 aufgebracht, welche für eine Bedruckung, eine Laserbeschriftung oder für Elemente von Beschriftungseinlegern, beispielsweise für ein Logo, Funktionskennzeichnungen oder Funktionsbeschreibungen, vorgesehen ist.

Auf die Schicht bzw. Lage für integrierte Bedienelemente 38 mit der integrierten elektromechanische Schnittstelle 33 zur Kontaktierung mit dem ortsfest installiertem ersten Schaltteil 20 ist zum Schutz, insbesondere auch der optional in einer Zwischenschicht 39 integrierten elektronischen Komponenten 39, eine transparente Versiegelung oder Deckschicht 40 aufgebracht.

Als elektronische Komponenten 39 sind u.a. ein RFID-Tag und eine Statusanzeige mittels LED (light emitting diode) oder OLED (organic light emitting diode) vorzugsweise von einer Kunststofffolie, aufgenommen.

In einer bevorzugten Ausführung schließt der Grundkörper 31 mit einer Schicht 36 ab, welche OLED's und/oder LED's 36 für die Beleuchtung des Bedienelements 30 aufweist.

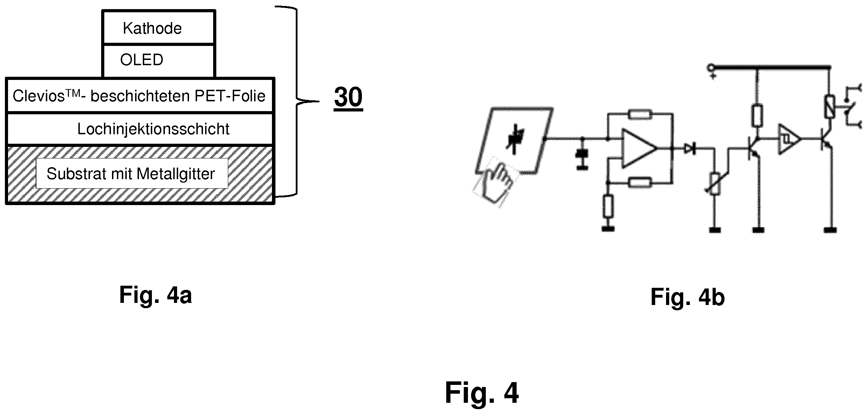

In der **Fig.** 4a ist ein beispielhafter Aufbau eines als kapazitiver Touchsensor arbeitenden Bedienteils 30 des elektrischen Schaltgerätes gezeigt, wobei die Kunststofffolie aus einer aus dem Stand der Technik bekannten Clevios™- beschichteten PET-Folie gebildet ist, die beispielsweise die folgenden Schichten aufweist:
- eine gedruckte Kathode oder Anode als gedruckte leitfähige Schicht oder Leiterbahnen,
- eine gedruckte organische lichtemittierenden oder -absorbierenden Schicht als OLED,
- eine Lochinjektionsschicht, auch als Hole-injection- layer (HIL) bekannt, und
- eine hochleitfähige Metallschicht, welche auf einem Substrat mit Metallgitter angeordnet ist.

Der so gebildete Touchsensor detektiert über einen integrierten Schwingkreis eine Berührung, die als Schaltsignal für das elektrische Schaltgerät verwendet wird. Eine beispielhafte Ausführung des Schwingkreises zeigt die **Fig.** 4b.

### Bezugszeichenliste

- 1: elektrisches Schaltgerät, Installationsschalter, Gebäudeautomatisierungsgerät
- 20: erstes Schaltteil
- 23: elektromechanische Schnittstelle des ersten Schaltteils
- 30: zweites Schaltteil, Bedienteil
- 31: Grundkörper des zweiten Schaltteiles
- 32: Schaltfläche
- 33: elektromechanische Schnittstelle des Bedienteiles, Kontaktierungselemente
- 35: leitfähigen Polymer-Beschichtungen, Bedienfläche, Touch- Display
- 36: Beleuchtungskörper, OLED, LED
- 37: Bedruckung, Elemente für Beschriftungseinleger oder eine Laserbeschriftung
- 38: Funktionsfläche für Schaltflächen und Kontaktierung mit dem ersten Schaltteil, Schicht bzw. Lage für integrierte Bedienelemente
- 39: elektronischen Komponenten, RFID-Tag, Statusanzeige mittels LED, OLED
- 40: Versiegelung, Deckschicht

## Patentansprüche

1. Elektrisches Schaltgerät der Haus- oder Gebäudeinstallation, das als Unterputz- oder Aufputz-Installationsgerät ausgeführt ist, und welches aus wenigstens einem ortsfest installierbaren ersten Schaltteil (20) und wenigstens einem vom ortsfest installierbaren ersten Schaltteil (20) abnehmbaren zweiten Schaltteil (30) aufgebaut ist, wobei das wenigstens eine zweite Schaltteil (30) aus mindestens einem transparenten Material gebildet ist und wenigstens eine berührungsempfindliche Schaltfläche (32) aufweist, mit der Bedienungen des Schaltgerätes (1) ausführbar sind,
**dadurch gekennzeichnet, dass**
das zweite Schaltteil (30) mit einer Personalisierungsfunktion und mit einer Mitnahmefunktion ausgestattet ist, wobei durch Trennung des zweiten Schaltteils (30) vom ersten Schaltteil (20) eine Schaltfunktion des zweiten Schaltteils (30) mitnehmbar ist.

2. Elektrisches Schaltgerät nach Anspruch 1, **dadurch gekennzeichnet, dass** das zweite Schaltteil (30) lediglich elektrisch leitfähige Schichten ohne zusätzliche elektronische Komponenten, wie RFID,-Tags, LED, OLED's, aufweist und aus einem transparenten Grundkörper (31) aufgebaut ist.

3. Elektrisches Schaltgerät nach Anspruch 1, **dadurch gekennzeichnet, dass** das zweite Schaltteil (30) elektronische Komponenten (39), wie ein RFID-Tag, Beleuchtungskörper für eine Statusanzeige und/oder ein Display (35) aufweist

4. Elektrisches Schaltgerät nach einem der vorherigen Ansprüche, **dadurch gekennzeichnet, dass** der transparente Grundkörper (31) aus einem Kunststoff oder einem Glassubstrat mit darauf aufgebrachten leitfähigen Polymer-Beschichtungen (35) aufgebaut ist.

5. Elektrisches Schaltgerät nach Anspruch 4, **dadurch gekennzeichnet, dass** der transparente Grundkörper (31) aus Kunststoff oder Glassubstrat mit einer starren, festen Oberfläche ausgeführt ist.

6. Elektrisches Schaltgerät nach Anspruch 4, **dadurch gekennzeichnet, dass** der transparente Grundkörper (31) aus einer Kunststofffolie oder einem flexiblen Glassubstrat mit einer flexiblen, biegbaren Oberfläche ausgeführt ist.

7. Elektrisches Schaltgerät nach einem der vorstehenden Ansprüche, **dadurch gekennzeichnet, dass** das zweite Schaltteil (30) als rechteckförmiges, quadratisches, dreieckförmiges oder rundes Bedienteil oder Bedienfläche (35) ausgeführt ist und einen flachen Aufbau mit einem nahezu zweidimensionalen Grundkörper (31) oder einen dreidimensionalen räumlichen Grundkörper (31) aufweist.

8. Elektrisches Schaltgerät nach einem der vorstehenden Ansprüche, **dadurch gekennzeichnet, dass** das zweite Schaltteil (30) Elemente (37) für Beschriftungen, wie Texte und/oder Symbole, durch Laserbeschriftung, Tampondruck, Gravierung, Siebdruck, Digitaldruck oder Elemente für Beschriftungseinleger (37) aufweist.

9. Elektrisches Schaltgerät nach einem der vorherigen Ansprüche, **dadurch gekennzeichnet, dass** die im zweiten Schaltteil (30) integrierte Personaiisierungsfunktion einen Zugriff auf Gebäude- oder Raumfunktionen über entsprechend an die Zugriffsberechtigung für die jeweiligen Gebäude- oder Raumfunktionen durch entsprechende Bedienteilausgestaltungen für unterschiedliche Nutzer ermöglicht.

10. Elektrisches Schaltgerät nach einem der vorstehenden Ansprüche, **dadurch gekennzeichnet, dass** das als Bedienteil ausgeführte zweite Schaltteil (30) eine 2-fach oder mehrfach Schaltfläche (32) für einen 1-fach oder mehrfach Schalter, einen gerader Schieberegler oder kreisförmiger Schieberegler für einen Drehregler aufweist.

11. Elektrisches Schaltgerät nach einem der vorstehenden Ansprüche, welches ein Installationsschalter oder ein Gebäudeautomatisierungsgerät der Haus- oder Gebäudeinstallation in Unterputz- oder Aufputzausführung ist.

## Claims

1. Electrical switching device for house or building installation, which electrical switching device is embodied as a flush-mounted or surface-mounted installation device and is constructed from at least one first switching part (20) that is able to be installed in a stationary manner and at least one second switching part (30) that is detachable from the first switching part (20) that is able to be installed in a stationary manner, wherein the at least one second switching part (30) is formed from at least one transparent material and has at least one touch-sensitive switching area (32) with which operator control processes of the switching device (1) are implementable,
**characterized in that**
the second switching part (30) is equipped with a personalization function and with a transfer function, wherein a switching function of the second switching part (30) is transferable as a result of the separation of the second switching part (30) from the first switching part (20).

2. Electrical switching device according to Claim 1, **characterized in that** the second switching part (30) only comprises electrically conductive layers without additional electronic components, such as RFID tags, LED, OLEDs, and is constructed from a transparent main body (31).

3. Electrical switching device according to Claim 1, **characterized in that** the second switching part (30) comprises electronic components (39), such as an RFID tag, illumination bodies for a status indicator and/or a display (35).

4. Electrical switching device according to any of the preceding claims, **characterized in that** the transparent main body (31) is constructed from a plastic or a glass substrate with conductive polymer coatings (35) applied thereto.

5. Electrical switching device according to Claim 4, **characterized in that** the transparent main body (31) is made from plastic or glass substrate with a rigid, fixed surface.

6. Electrical switching device according to Claim 4, **characterized in that** the transparent main body (31) is made from a plastic film or a flexible glass substrate with a flexible, bendable surface.

7. Electrical switching device according to any of the preceding claims, **characterized in that** the second switching part (30) is embodied as a rectangular, square, triangular or round operator control part or operator control area (35) and has a flat construction with a virtually two-dimensional main body (31) or a three-dimensional spatial main body (31) .

8. Electrical switching device according to any of the preceding claims, **characterized in that** the second switching part (30) comprises elements (37) for inscriptions, such as texts and/or symbols, by laser inscription, pad printing, engraving, screen printing, digital printing or elements for inscription inlays (37).

9. Electrical switching device according to any of the preceding claims, **characterized in that** the personalization function integrated in the second switching part (30) allows access to building or room functions for different users by way of correspondingly to the access authorization for the respective building or room functions by means of corresponding operator control part configurations.

10. Electrical switching device according to any of the preceding claims, **characterized in that** the second switching part (30) embodied as an operator control part comprises a double or multiple switching area (32) for a single or multiple switch, a straight sliding controller or a circular sliding controller for a rotary controller.

11. Electrical switching device according to any of the preceding claims, which is an installation switch or a building automation device for house or building installation that is embodied in a flush-mounted or surface-mounted fashion.

## Revendications

1. Appareil de commutation électrique destiné à des installations intérieures, qui est réalisé sous la forme d'un appareil pour installation encastrée ou apparente, et qui est composé d'au moins un premier élément de commutation (20) pouvant être installé de manière stationnaire et d'au moins un deuxième élément de commutation (30) pouvant être retiré dudit au moins un premier élément de commutation (20) pouvant être installé de manière stationnaire, dans lequel ledit au moins un deuxième élément de commutation (30) est formé d'au moins un matériau transparent et présente au moins un bouton de commande (32) tactile permettant d'effectuer des commandes de l'appareil de commutation (1),
**caractérisé en ce que** le deuxième élément de commutation (30) est équipé d'une fonction de personnalisation et d'une fonction de synchronisation, la séparation du deuxième élément de commutation (30) du premier élément de commutation (20) pouvant synchroniser une fonction de commutation du deuxième élément de commutation (30).

2. Appareil de commutation électrique selon la revendication 1, **caractérisé en ce que** le deuxième élément de commutation (30) présente uniquement des couches électriquement conductrices sans composants électroniques supplémentaires, tels que des étiquettes RFID, des LED, des OLED, et se compose d'un corps de base (31) transparent.

3. Appareil de commutation électrique selon la revendication 1, **caractérisé en ce que** le deuxième élément de commutation (30) présente des composants électroniques (39), tels qu'une étiquette RFID, un luminaire pour un affichage d'état et/ou un affichage (35) .

4. Appareil de commutation électrique selon l'une quelconque des revendications précédentes, **caractérisé en ce que** le corps de base transparent (31) est composé d'une matière synthétique ou d'un substrat de verre doté(e) de revêtements polymères conducteurs (35) appliqués sur celle-ci ou celui-ci.

5. Appareil de commutation électrique selon la revendication 4, **caractérisé en ce que** le corps de base transparent (31) est réalisé en matière synthétique ou en substrat de verre doté(e) d'une surface solide et rigide.

6. Appareil de commutation électrique selon la revendication 4, **caractérisé en ce que** le corps de base transparent (31) est réalisé d'un film plastique ou d'un substrat de verre flexible ayant une surface souple et flexible.

7. Appareil de commutation électrique selon l'une quelconque des revendications précédentes, **caractérisé en ce que** le deuxième élément de commutation (30) est réalisé sous la forme d'un élément de commande ou d'une surface de commande (35) rectangulaire, carré(e), triangulaire ou rond(e) et présente une structure plate avec un corps de base (31) presque bidimensionnel ou un corps de base (31) spatial en trois dimensions.

8. Appareil de commutation électrique selon l'une quelconque des revendications précédentes, **caractérisé en ce que** le deuxième élément de commutation (30) présente des éléments (37) destinés aux marquages, tels que des textes et/ou des symboles, par marquage au laser, tampographie, gravure, sérigraphie, impression numérique ou des éléments pour des inserts de marquage (37) .

9. Appareil de commutation électrique selon l'une quelconque des revendications précédentes, **caractérisé en ce que** la fonction de personnalisation intégrée dans le deuxième élément de commutation (30) permet à différents utilisateurs un accès à des fonctions de bâtiment ou de local par de manière correspondante à l'autorisation d'accès pour les fonctions de bâtiment ou de local respectives par des configurations d'élément de commande correspondantes.

10. Appareil de commutation électrique selon l'une quelconque des revendications précédentes, **caractérisé en ce que** le deuxième élément de commutation (30) réalisé sous la forme d'un élément de commande présente un bouton de commande (32) double ou multiple pour un commutateur simple ou multiple, un curseur linéaire ou un curseur circulaire pour un bouton rotatif.

11. Appareil de commutation électrique selon l'une quelconque des revendications précédentes, qui est un interrupteur d'installation ou un appareil d'automatisation de bâtiments destiné à des installations intérieures dans une version encastrée ou apparente.
